# EUROPEAN PATENT APPLICATION

(11) **EP 4 503 877 A1**
(43) Date of publication of application: **05.02.2025**
(21) Application number: 24189491.4
(22) Date of filing: 18.07.2024
(51) Int. Cl.: H05K 7/14

(54) **DISPLAY MOUNT**

(30) Priority: 30.07.2023 US 202363516526 P
(71) Applicant: Vertiv Corporation, Westerville, OH 43082 (US)
(72) Inventor: RATKOVIC, Igor, 10000 Zagreb (HR); MATOVINA, Tomislav, 10000 Zagreb (HR)
(74) Representative: Bryn-Jacobsen, Caelia

(57) **Abstract**

An uninterruptible power supply device can provide electrical power to one or more computing devices and can include one or more hot swappable modules coupled thereto and/or a display module rotatably coupled thereto. The display module can selectively rotate to block and/or allow removal of the hot swappable modules.

## Description

### CROSS REFERENCE TO RELATED APPLICATIONS

This application claims the benefit of US Provisional Patent Application No. 63/516,526 filed July 30, 2023.

### STATEMENT REGARDING FEDERALLY SPONSORED RESEARCH OR DEVELOPMENT

Not applicable.

### REFERENCE TO APPENDIX

Not applicable.

### BACKGROUND OF THE INVENTION

Field of the Invention. The present disclosure relates generally to mounting systems for displays and more specifically relates to display mounts for rack mounted uninterruptible power supplies.

### Description of the Related Art.

Some rack mounted uninterruptible power supplies (UPS) include hot swappable modules, such as batteries and/or power modules. However, since such modules are often removed from a front side of the UPS and any display assembles are often mounted in front of the modules, such display assemblies often obstruct the path of module removal. Removal of display assemblies, such as to facilitate module removal, can be complicated and/or damage display wiring.

### BRIEF SUMMARY OF THE INVENTION

Applicant has created new and useful devices, systems and methods for display mounts for rack mounted equipment. In at least one example, a cabinet mounted computing system can include a rack mounting system, one or more computing devices coupled to the rack mounting system, one or more uninterruptible power supply devices coupled to the rack mounting system, or any combination thereof. In at least one example, the uninterruptible power supply device can provide electrical power to the computing devices. In at least one example, the uninterruptible power supply device can include one or more hot swappable modules mounted therewithin or otherwise coupled thereto and/or a display module rotatably coupled thereto. In at least one example, the display module can selectively block and/or selectively allow removal of the hot swappable module.

In at least one example, the uninterruptible power supply device can include a first hot swappable module mounted therewithin or otherwise coupled thereto and a second hot swappable module mounted therewithin or otherwise coupled thereto. In at least one example, the display module can block removal of the first hot swappable module and/or allow removal of the second hot swappable module in a first position. In at least one example, the display module can allow removal of the first hot swappable module and/or block removal of the second hot swappable module in a second position. In at least one example, the display module can block removal of the first hot swappable module and the second hot swappable module in a third position. In at least one example, the uninterruptible power supply device can include a removable front bezel configured to selectively cover the hot swappable module and/or at least a portion of the display module, such as when the display module is in the third position.

In at least one example, the display module can be rotatably coupled to a double hinged bracket of the uninterruptible power supply device. For example, in at least one example, the display module can be fixedly coupled to a display plate of the bracket. In at least one example, the display plate can be rotatably coupled to an intermediate linkage of the bracket. In at least one example, the intermediate linkage can be rotatably coupled to a mounting flange of the bracket. In at least one example, the mounting flange can be fixedly coupled to the uninterruptible power supply device. In at least one example, the intermediate linkage can be rotatably coupled to the display plate and/or the mounting flange through friction hinges. In at least one example, the display plate can be rotatably coupled to the intermediate linkage of the bracket through a display flange. In at least one example, the display plate can be removably coupled to the display flange.

In at least one example, an uninterruptible power supply device can be coupled to a rack mounting system, can be configured to provide electrical power to at least one computing device, and/or can include a housing, a frame within the housing, a first hot swappable module disposed within the housing and adjacent to the frame, a second hot swappable module disposed within the housing and adjacent to the frame, a display module rotatably coupled to the frame, or any combination thereof.

In at least one example, the display module can selectively block removal of the first hot swappable module and/or allow removal of the second hot swappable module in a first position. In at least one example, the display module can selectively allow removal of the first hot swappable module and/or block removal of the second hot swappable module in a second position. In at least one example, the display module can block removal of the first hot swappable module and the second hot swappable module in a third position. In at least one example, the uninterruptible power supply device can include a removable front bezel configured to selectively cover the hot swappable modules and at least a portion of the display module, such as when the display module is in the third position.

In at least one example, the uninterruptible power supply device can include including a mounting flange fixedly mounted to the frame, an intermediate linkage rotatably coupled to the mounting flange, a display plate rotatably coupled to the intermediate linkage, or any combination thereof. In at least one example, the display module can be coupled to the display plate. In at least one example, the intermediate linkage can be rotatably coupled to the display plate and/or the mounting flange through friction hinges. In at least one example, the display plate can be rotatably coupled to the intermediate linkage of the bracket through a display flange. In at least one example, the display plate can be removably coupled to the display flange.

In at least one example, an uninterruptible power supply device can be coupled to a rack mounting system, can be configured to provide electrical power to at least one computing device, and/or can include a housing, a frame within the housing, a first hot swappable module disposed within the housing and adjacent to the frame, a second hot swappable module disposed within the housing and adjacent to the frame, a mounting flange fixedly coupled to the frame, an intermediate linkage rotatably coupled to the mounting flange, a display flange rotatably coupled to the intermediate linkage, a display plate coupled to the display flange, a display module removably and/or fixedly coupled to the display plate, or any combination thereof. In at least one example, the intermediate linkage can be rotatably coupled to the display flange and/or the mounting flange through friction hinges.

In at least one example, the display module can selectively block removal of the first hot swappable module and/or allow removal of the second hot swappable module in a first position. In at least one example, the display module can selectively allow removal of the first hot swappable module and/or block removal of the second hot swappable module in a second position. In at least one example, the display module can block removal of the first hot swappable module and the second hot swappable module in a third position. In at least one example, the uninterruptible power supply device can include a removable front bezel configured to selectively cover the hot swappable modules and at least a portion of the display module, such as when the display module is in the third position.

### BRIEF DESCRIPTION OF THE SEVERAL VIEWS OF THE DRAWINGS

FIG. 1 is a perspective view of one of many examples of a rack system according to the disclosure.
FIG. 2 is a front elevation view of one of many examples of an uninterruptible power supply according to the disclosure.
FIG. 3 is a rear elevation view of one of many examples of an uninterruptible power supply according to the disclosure.
FIG. 4 is a partial exploded perspective view of one of many examples of an uninterruptible power supply according to the disclosure.
FIG. 5 is another partial exploded perspective view of one of many examples of an uninterruptible power supply according to the disclosure.
FIG. 6 is a partial plan view of one of many examples of an uninterruptible power supply according to the disclosure.
FIG. 7 is a partial plan view of one of many examples of an uninterruptible power supply according to the disclosure.
FIG. 8 is a partial plan view of one of many examples of an uninterruptible power supply according to the disclosure.
FIG. 9 is a perspective view of one of many examples of a display mount according to the disclosure.
FIG. 10 is an exploded perspective view of the display mount of FIG. 9.
FIG. 11 is a perspective view of another of many examples of a display mount according to the disclosure.
FIG. 12 is an exploded perspective view of the display mount of FIG. 11.
FIG. 13 is a partial exploded perspective view of another of many examples of an uninterruptible power supply according to the disclosure.

### DETAILED DESCRIPTION OF THE INVENTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to be limiting. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various examples of the present disclosure. In this regard, each block in a flowchart may represent a module, segment, or portion of code, which can include one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of flowchart illustration can be implemented by special purpose hardware-based systems that perform the specified functions or acts, or combinations of special purpose hardware and computer instructions.

Applicant has created new and useful devices, systems and methods for display mounts for rack mounted equipment. In at least one example, a computing system according to the disclosure can include a rack mounting system, one or more computing devices coupled to the rack mounting system, and one or more uninterruptible power supplies (UPSs) or UPS devices coupled to the rack mounting system. The system can include one or more hot swappable modules and one or more display modules, which can include one or more rotatably coupled display modules. In at least one example, one or more display modules can selectively block and/or allow removal of one or more hot swappable modules. In at least one example, one or more UPS devices can include a removable front bezel for selectively covering one or more hot swappable modules and/or at least a portion of one or more display modules.

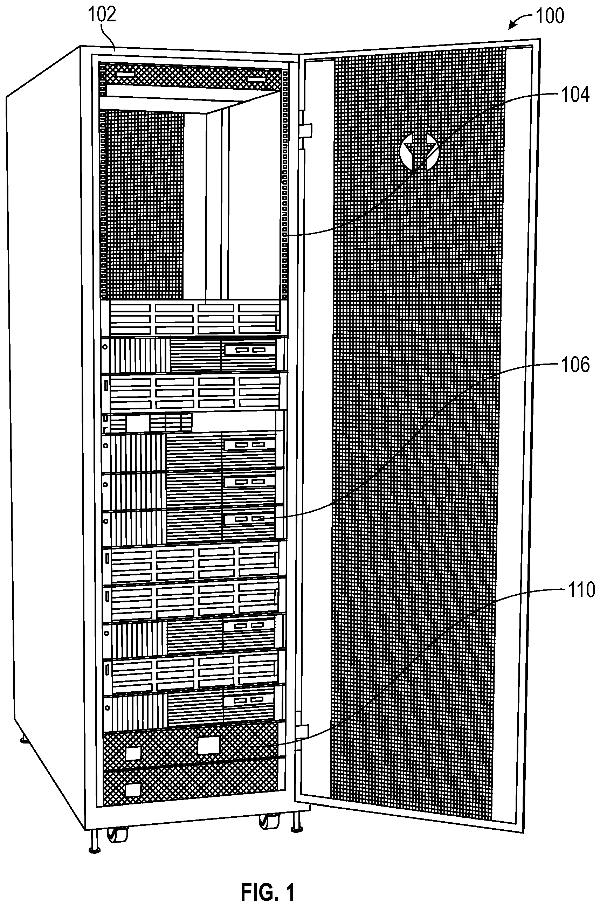

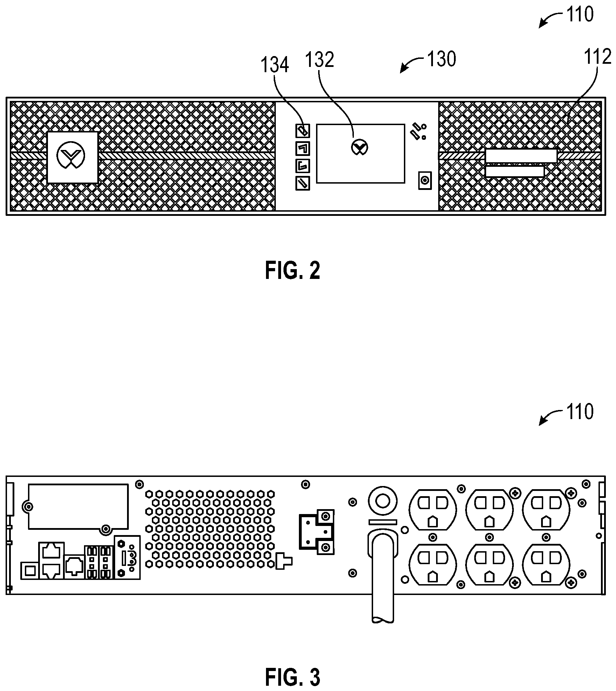

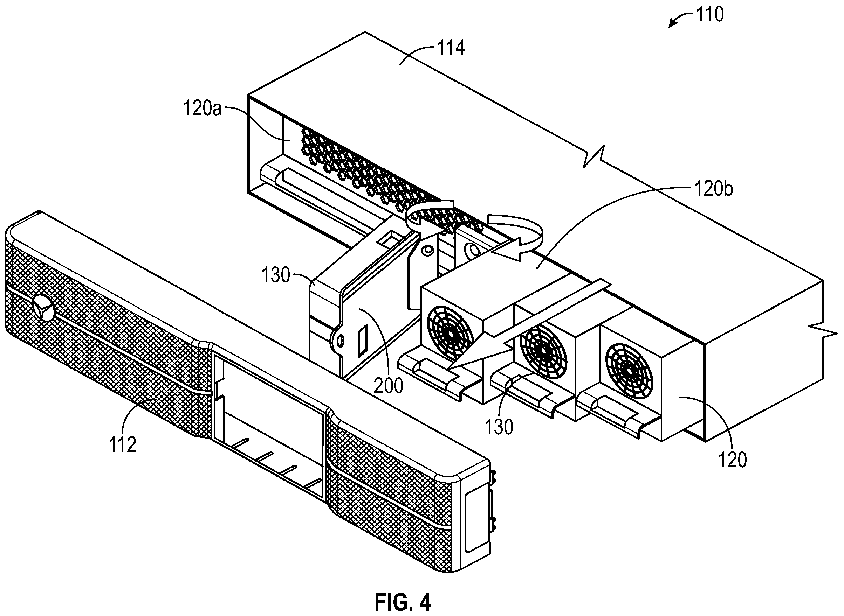

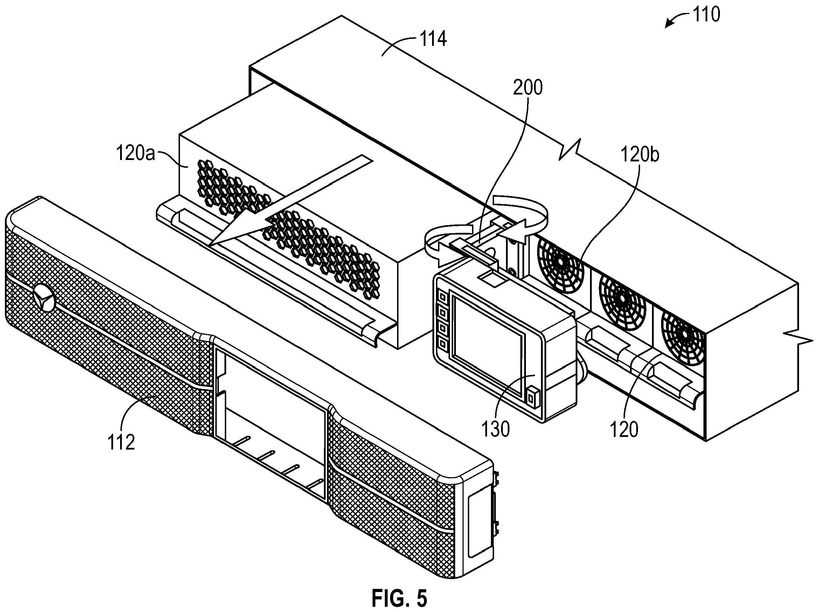

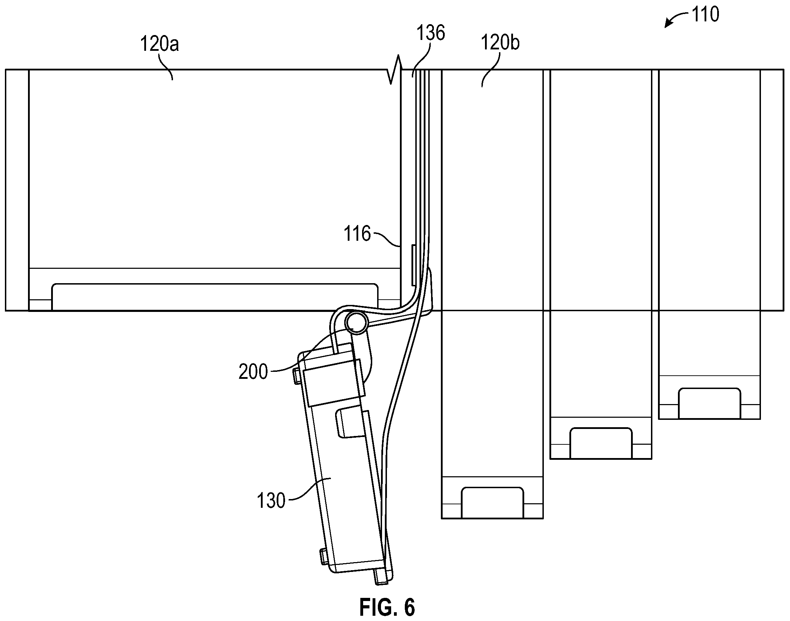

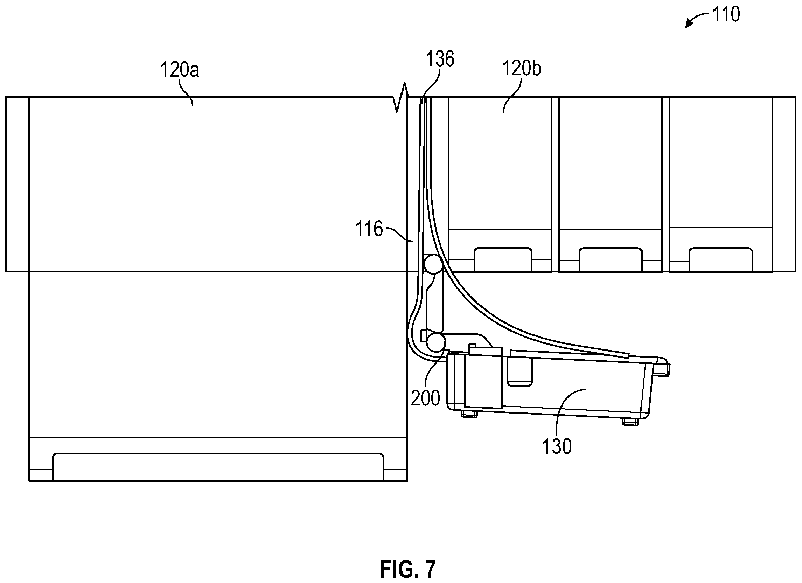

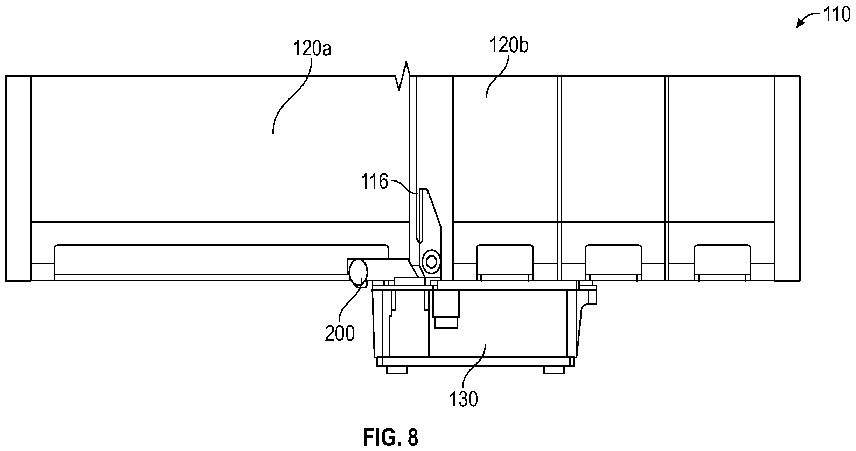

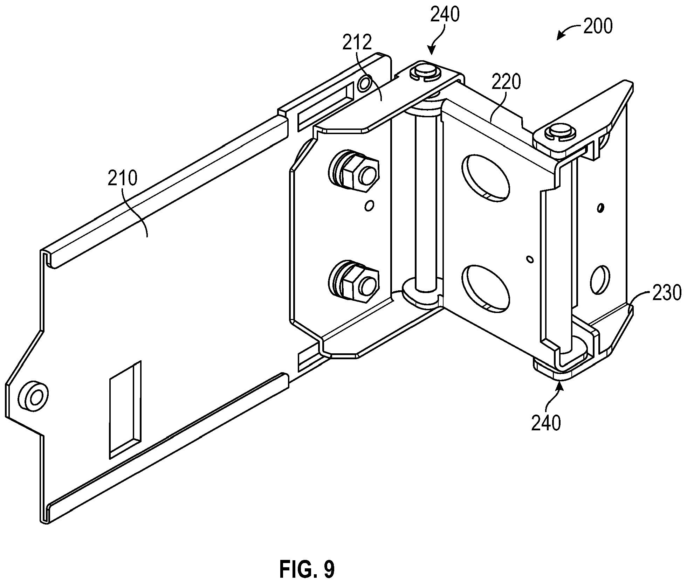

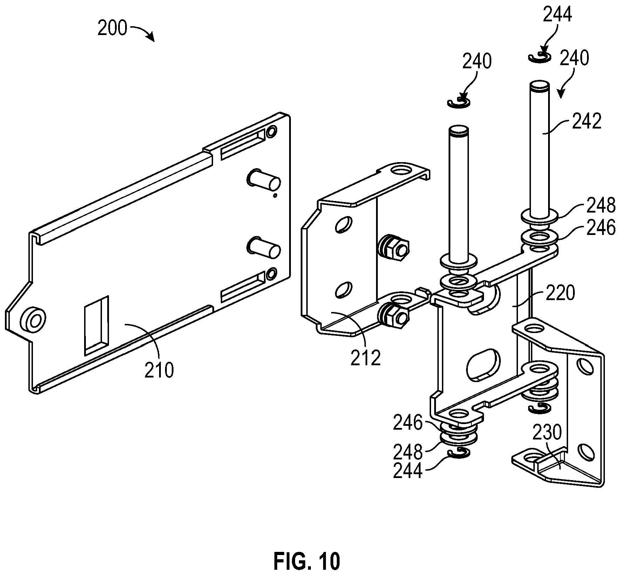

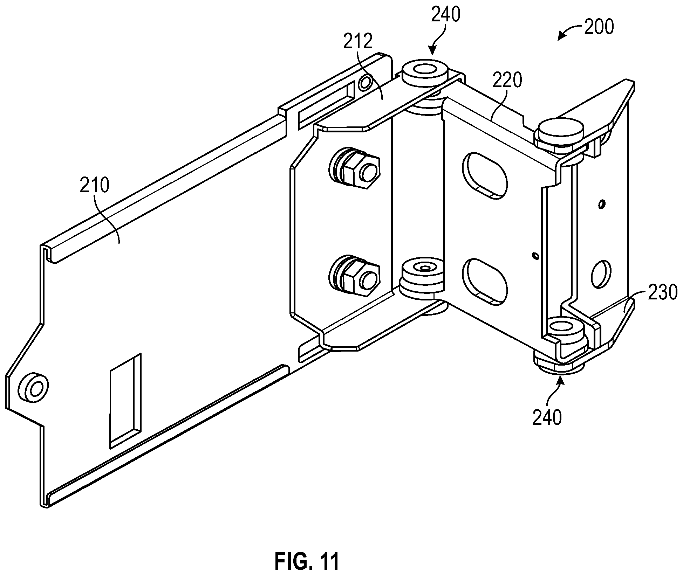

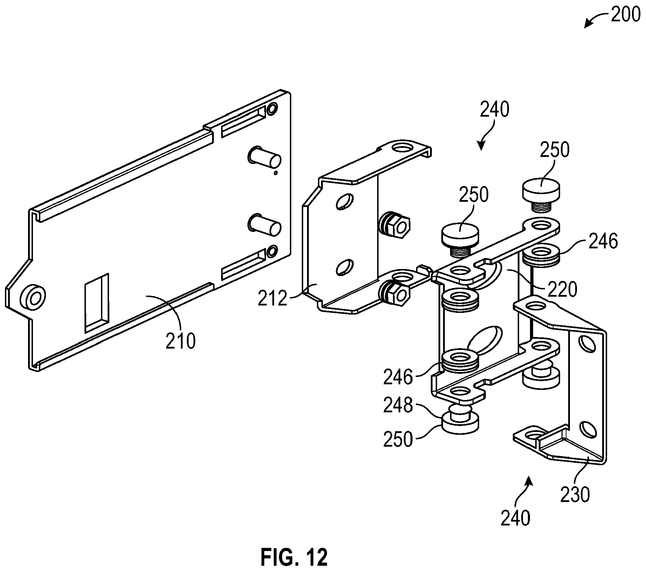

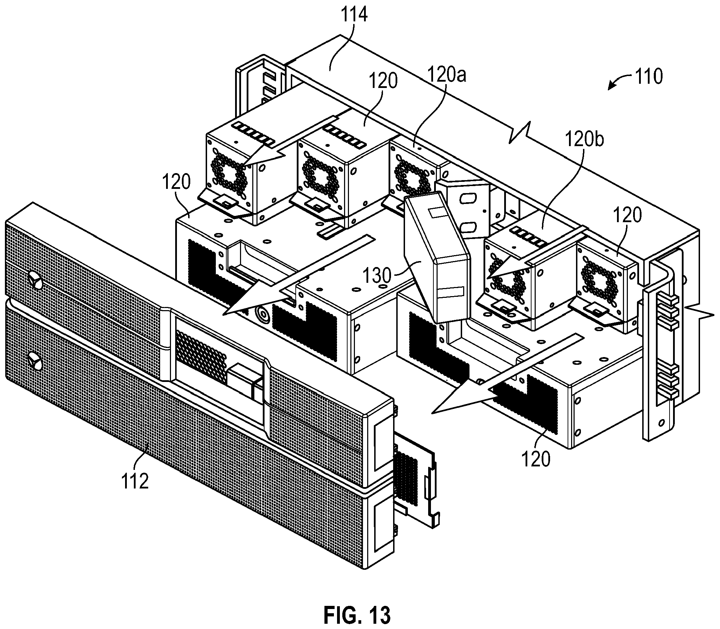

FIG. 1 is a perspective view of one of many examples of a rack system according to the disclosure. FIG. 2 is a front elevation view of one of many examples of an uninterruptible power supply according to the disclosure. FIG. 3 is a rear elevation view of one of many examples of an uninterruptible power supply according to the disclosure. FIG. 4 is a partial exploded perspective view of one of many examples of an uninterruptible power supply according to the disclosure. FIG. 5 is another partial exploded perspective view of one of many examples of an uninterruptible power supply according to the disclosure. FIG. 6 is a partial plan view of one of many examples of an uninterruptible power supply according to the disclosure. FIG. 7 is a partial plan view of one of many examples of an uninterruptible power supply according to the disclosure. FIG. 8 is a partial plan view of one of many examples of an uninterruptible power supply according to the disclosure. FIG. 9 is a perspective view of one of many examples of a display mount according to the disclosure. FIG. 10 is an exploded perspective view of the display mount of FIG. 9. FIG. 11 is a perspective view of another of many examples of a display mount according to the disclosure. FIG. 12 is an exploded perspective view of the display mount of FIG. 11. FIG. 13 is a partial exploded perspective view of another of many examples of an uninterruptible power supply according to the disclosure. FIGS. 1-13 are described in conjunction with one another.

In at least one example, a cabinet mounted computing system 100 according to the disclosure can include one or more cabinets 102, one or more rack mounting systems 104, one or more computing devices 106, one or more uninterruptible power supply devices (UPS) 110, or any combination thereof. In at least one example, rack mounting system 104 can be disposed at least partially within cabinet 102. In at least one example, computing devices 106 and/or UPS 110 can be coupled to rack mounting system 104.

In at least one example, UPS 110 can provide electrical power to computing devices 106. In at least one example, computing devices 106 can include one or more central processing units (CPU), one or more graphics processing units (GPU), one or more data processing units, one or more data storage units, one or more networking devices, or any combination thereof.

In at least one example, UPS 110 can include one or more hot swappable modules 120 disposed at least partially therein or otherwise coupled thereto and/or a display module 130 rotatably coupled thereto. Suitable uninterruptible power supply devices include, but are not limited to, Vertiv GXT5 devices and/or similar uninterruptible power supply devices. In at least one example, hot swappable modules 120 can include one or more battery modules 120a, one or more power modules 120b, or any combination thereof. In at least one example, battery modules 120a can include one or more batteries to supply power to computing devices 106, such as in the event of power failure. In at least one example, power modules 120b can include power electronics, such as those used to invert battery power and/or condition power, such as that from the batteries and/or that going to the computing devices 106. In at least one example, any one or more of the hot swappable modules 120 can be removed and/or replaced without limiting operation of other hot swappable modules 120. For example, a battery module 120a can be removed while another battery module 120a carries the load.

In at least one example, display module 130 can include one or more display screens 132, which can include touchscreens, and/or one or more inputs 134, such as buttons or touchscreens. In at least one example, display module 130 can include one or more user interface functions, which can be visual, tactile, audible, or any combination thereof.

In at least one example, display module 130 can selectively block and/or selectively allow removal of the hot swappable module. For example, any of hot swappable modules 120 and display module 130 can be accessible from a front of UPS 110. In at least one example, display module 130 can be positioned in front of any of hot swappable modules 120, such as in order to maximize space utilization within UPS 110.

In at least one example, UPS 110 can include a first hot swappable module 120a disposed at least partially therein or otherwise coupled thereto and a second hot swappable module 120b (and/or one or more additional hot swappable modules) disposed at least partially therein or otherwise coupled thereto. In at least one example, display module 130 can block removal of first hot swappable module 120a and/or allow removal of second hot swappable module 120b in a first position. In at least one example, display module 130 can allow removal of first hot swappable module 120a and/or block removal of second hot swappable module 120b in a second position. In at least one example, display module 130 can block removal of first hot swappable module 120a and/or second hot swappable module 120b in a third position. In at least one example, UPS 110 can include a removable front bezel 112 configured to selectively cover hot swappable modules 120 and/or at least a portion of display module 130, such as when display module 130 is in the third position.

In at least one example, display module 130 can be rotatably coupled to a double hinged bracket 200 of UPS 110. For example, in at least one example, display module 130 can be fixedly mounted to one or more display plates 210 of bracket 200. In at least one example, display plate 210 can be rotatably coupled to one or more intermediate linkage 220 of bracket 200. In at least one example, intermediate linkage 220 can be rotatably coupled to one or more mounting flanges 230 of bracket 200. In at least one example, mounting flange 230 can be fixedly mounted to UPS 110. In at least one example, intermediate linkage 220 can be rotatably coupled to display plate 210 and/or mounting flange 230 through friction hinges 240. In at least one example, display plate 210 can be rotatably coupled to intermediate linkage 220 of bracket 200 through one or more display flanges 212.

In at least one example, display plate 210 can be removably coupled to display flange 212. In at least one example, display plate 210 can be customized for display module 130 and/or swapped out with display module 130. For example, one specific display module 130 can have a specifically designed display plate 210, while another specific display module 130 can have another, different specifically designed display plate 210, and either of the display modules 130, with its corresponding display plate 210, can be selectively and interchangeably coupled to display flange 212 without requiring further modification of bracket 200.

In at least one example, any or all friction hinges 240 can include one or more pivot pins 242, one or more retainer clips 244, one or more resilient washers 246, one or more flat washers 248, one or more shoulder rivets 250, or any combination thereof. In at least one example, retainer clips 244 retain pivot pins 242 and/or other components of bracket 200 in position with respect to display plate 210, display flange 212, intermediate linkage 220, and/or mounting flange 230.

In at least one example, resilient washers 246 can include one or more spring washers and/or one or more elastic discs. In at least one example, resilient washers 246 provide for rotation of display plate 210, display flange 212, intermediate linkage 220, and/or mounting flange 230 about pivot pins 242 and/or shoulder rivets 250, thereby allowing a user to place the display module 130 in any desired position. In at least one example, resilient washers 246 provide some frictional resistance to rotation of display plate 210, display flange 212, intermediate linkage 220, and/or mounting flange 230 about pivot pins 242 and/or shoulder rivets 250, thereby holding display module 130 in the desired position, as selected by the user.

In at least one example, bracket 200 can protect communication and/or power cabling 136 for the display module 130. For example, any or all of display plate 210, display flange 212, intermediate linkage 220, and/or mounting flange 230 of bracket 200 can include cable management and/or protection features, such as to ensure kinkless and/or snagless routing of the cabling 136 for the display module 130.

In at least one example, mounting flange 230 can be integral to frame 116, housing 116, or another component of UPS 110. In at least one example, display plate 210 can be integral to display module 130 and/or display flange 212.

In at least one example, a UPS 110 according to the disclosure can be coupled to a rack mounting system 104, can be configured to provide electrical power to one or more computing devices 106, and/or can include one or more housings 114, one or more frames 116, one or more hot swappable modules 120, one or more display modules 130, or any combination thereof. In at least one example, frame 116 can be disposed at least partially within housing 114 and/or be external thereto. In at least one example, hot swappable modules 120 can include a first and second hot swappable modules 120a, 120b, which can be coupled within housing 114 and/or adjacent to frame 116. In at least one example, display module 130 can be rotatably coupled to frame 114, housing 116, or another component of UPS 110.

In at least one example, display module 130 can selectively block removal of first hot swappable module 120a and/or allow removal of second hot swappable module 120b in a first position. In at least one example, display module 130 can selectively allow removal of first hot swappable module 120a and/or block removal of second hot swappable module 120b in a second position. In at least one example, display module 130 can block removal of first hot swappable module 120a and/or second hot swappable module 120b in a third position. In at least one example, UPS 110 can include one or more removable front bezels 112 configured to selectively cover hot swappable modules 120 and/or at least a portion of display module 130, such as when display module 130 is in the third position.

In at least one example, UPS 110 can include including one or more mounting flanges 230 fixedly mounted to frame 116, one or more intermediate linkages 220 rotatably coupled to mounting flange 230, one or more display plates 210 rotatably coupled to intermediate linkage 230, or any combination thereof. In at least one example, display module 130 can be removably and/or fixedly coupled to display plate 210. In at least one example, intermediate linkage 220 can be rotatably coupled to display plate 210 and/or mounting flange 230 through friction hinges 240. In at least one example, display plate 210 can be rotatably coupled to intermediate linkage 220 through one or more display flanges 212. In at least one example, display plate 210 can be removably coupled to display flange 212.

In at least one example, a UPS 110 according to the disclosure can be coupled to a rack mounting system 104, can be configured to provide electrical power to one or more computing devices 106, and/or can include one or more housings 114, one or more frames 116 within housing 116, one or more hot swappable modules 120 disposed at least partially within housing 114 and/or adjacent to frame 116, one or more mounting flanges 230 fixedly coupled to frame 116, one or more intermediate linkages 220 rotatably coupled to mounting flange 230, one or more display flanges 212 rotatably coupled to intermediate linkage 220, one or more display plates 210 removably and/or fixedly mounted to display flange 212, one or more display modules 130 removably and/or fixedly mounted to display plate 210, or any combination thereof. In at least one example, intermediate linkage 220 can be rotatably coupled to display flange 212 and/or mounting flange 230 through friction hinges 240.

In at least one example, UPS 110 can include first and second hot swappable modules 120a, 120b. In at least one example, display module 130 can selectively block removal of first hot swappable module 120a and/or allow removal of second hot swappable module 120b in a first position. In at least one example, display module 130 can selectively allow removal of first hot swappable module 120a and/or block removal of second hot swappable module 120b in a second position. In at least one example, display module 130 can block removal of any or all of the hot swappable modules 120 in a third position. In at least one example, UPS 110 can include one or more removable front bezels 112 configured to selectively cover any or all of hot swappable modules and/or display module 130, such as when display module 130 is in the third position.

In at least one example, a cabinet mounted computing system can include a rack mounting system, one or more computing devices coupled to the rack mounting system, one or more uninterruptible power supply devices coupled to the rack mounting system, or any combination thereof. In at least one example, the uninterruptible power supply devices can provide electrical power to the computing devices. In at least one example, the uninterruptible power supply devices can include one or more hot swappable modules disposed at least partially therein or otherwise coupled thereto and/or a display module rotatably coupled thereto. In at least one example, the display module can selectively block and/or selectively allow removal of one or more hot swappable modules.

In at least one example, the uninterruptible power supply device can include a first hot swappable module mounted therewithin or otherwise coupled thereto and a second hot swappable module mounted therewithin or otherwise coupled thereto. In at least one example, the display module can block removal of the first hot swappable module and/or allow removal of the second hot swappable module in a first position. In at least one example, the display module can allow removal of the first hot swappable module and/or block removal of the second hot swappable module in a second position. In at least one example, the display module can block removal of the first hot swappable module and the second hot swappable module in a third position. In at least one example, the uninterruptible power supply device can include a removable front bezel configured to selectively cover the hot swappable module and/or at least a portion of the display module, such as when the display module is in the third position.

In at least one example, the display module can be rotatably coupled to a double hinged bracket of the uninterruptible power supply device. For example, in at least one example, the display module can be fixedly coupled to a display plate of the bracket. In at least one example, the display plate can be rotatably coupled to an intermediate linkage of the bracket. In at least one example, the intermediate linkage can be rotatably coupled to a mounting flange of the bracket. In at least one example, the mounting flange can be fixedly coupled to the uninterruptible power supply device. In at least one example, the intermediate linkage can be rotatably coupled to the display plate and/or the mounting flange through friction hinges. In at least one example, the display plate can be rotatably coupled to the intermediate linkage of the bracket through a display flange. In at least one example, the display plate can be removably coupled to the display flange.

In at least one example, an uninterruptible power supply device can be coupled to a rack mounting system, can be configured to provide electrical power to at least one computing device, and/or can include a housing, a frame within the housing, a first hot swappable module disposed at least partially within the housing and adjacent to the frame, a second hot swappable module disposed at least partially within the housing and adjacent to the frame, a display module rotatably mounted to the frame, or any combination thereof.

In at least one example, the display module can selectively block removal of the first hot swappable module and/or allow removal of the second hot swappable module in a first position. In at least one example, the display module can selectively allow removal of the first hot swappable module and/or block removal of the second hot swappable module in a second position. In at least one example, the display module can block removal of the first hot swappable module and the second hot swappable module in a third position. In at least one example, the uninterruptible power supply device can include a removable front bezel configured to selectively cover the hot swappable modules and at least a portion of the display module, such as when the display module is in the third position.

In at least one example, the uninterruptible power supply device can include a mounting flange coupled to the frame, an intermediate linkage rotatably coupled to the mounting flange, a display plate rotatably coupled to the intermediate linkage, or any combination thereof. In at least one example, the display module can be removably and/or fixedly coupled to the display plate. In at least one example, the intermediate linkage can be rotatably coupled to the display plate and/or the mounting flange through friction hinges. In at least one example, the display plate can be rotatably coupled to the intermediate linkage of the bracket through a display flange. In at least one example, the display plate can be removably coupled to the display flange.

In at least one example, an uninterruptible power supply device can be coupled to a rack mounting system, can be configured to provide electrical power to at least one computing device, and/or can include a housing, a frame within the housing, a first hot swappable module disposed at least partially within the housing and adjacent to the frame, a second hot swappable module disposed at least partially within the housing and adjacent to the frame, a mounting flange fixedly coupled to the frame, an intermediate linkage rotatably coupled to the mounting flange, a display flange rotatably coupled to the intermediate linkage, a display plate removably and/or fixedly coupled to the display flange, a display module removably and/or fixedly coupled to the display plate, or any combination thereof. In at least one example, the intermediate linkage can be rotatably coupled to the display flange and/or the mounting flange through friction hinges.

In at least one example, the display module can selectively block removal of the first hot swappable module and/or allow removal of the second hot swappable module in a first position. In at least one example, the display module can selectively allow removal of the first hot swappable module and/or block removal of the second hot swappable module in a second position. In at least one example, the display module can block removal of the first hot swappable module and the second hot swappable module in a third position. In at least one example, the uninterruptible power supply device can include a removable front bezel configured to selectively cover the hot swappable modules and at least a portion of the display module, such as when the display module is in the third position.

Other and further examples utilizing one or more aspects of the disclosure can be devised without departing from the scope of the disclosure. For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice-\versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

Further examples are set out in the clauses below:
1. A cabinet mounted computing system comprising: a rack mounting system;
   at least one computing device mounted to the rack mounting system; and
   at least one uninterruptible power supply device mounted to the rack mounting system;
   wherein the at least one uninterruptible power supply device is configured to provide electrical power to the at least one computing device;
   wherein the at least one uninterruptible power supply device includes at least one hot swappable module coupled thereto and a display module rotatably coupled thereto; and
   wherein the display module is configured to selectively block and selectively allow removal of the at least one hot swappable module.
2. The cabinet mounted computing system of clause 1, wherein the at least one uninterruptible power supply device further comprises a removable front bezel configured to selectively cover the at least one hot swappable module and at least a portion of the display module.
3. The cabinet mounted computing system of clause 1 or 2, wherein the at least one hot swappable module comprises a first hot swappable module and a second hot swappable module disposed at least partially within the at least one uninterruptible power supply device.
4. The cabinet mounted computing system of clause 3, wherein the display module blocks removal of the first hot swappable module and allows removal of the second hot swappable module in a first position and wherein the display module allows removal of the first hot swappable module and blocks removal of the second hot swappable module in a second position.
5. The cabinet mounted computing system of clause 4, wherein the display module blocks removal of the first hot swappable module and the second hot swappable module in a third position.
6. The cabinet mounted computing system of clause 5, wherein the at least one uninterruptible power supply device further comprises a removable front bezel configured to selectively cover the hot swappable modules and at least a portion of the display module, when the display module is in the third position.
7. The cabinet mounted computing system of any one of the preceding clauses, wherein the display module is rotatably mounted to a double hinged bracket of the at least one uninterruptible power supply device.
8. The cabinet mounted computing system of clause 7, wherein the display module is fixedly mounted to a display plate of the bracket.
9. The cabinet mounted computing system of clause 8, wherein the display plate is rotatably coupled to an intermediate linkage of the bracket.
10. The cabinet mounted computing system of clause 9, wherein the intermediate linkage is rotatably coupled to a mounting flange of the bracket and wherein the mounting flange is fixedly mounted to the at least one uninterruptible power supply device.
11. The cabinet mounted computing system of clause 10, wherein the intermediate linkage is rotatably coupled to the display plate and the mounting flange through friction hinges.
12. The cabinet mounted computing system of clause 8, wherein the display plate is rotatably coupled to the intermediate linkage of the bracket through a display flange and wherein the display plate is removably coupled to the display flange.
13. An uninterruptible power supply device for a rack mounting system and configured to provide electrical power to at least one computing device, the uninterruptible power supply device comprising: a housing; a frame within the housing;
   a first hot swappable module coupled to the housing and disposed adjacent to the frame;
   a second hot swappable module coupled to the housing and disposed adjacent to the frame; and
   a display module rotatably coupled to the frame, wherein the display module selectively blocks removal of the first hot swappable module and allows removal of the second hot swappable module in a first position and wherein the display module selectively allows removal of the first hot swappable module and blocks removal of the second hot swappable module in a second position.
14. The uninterruptible power supply device of clause 13, wherein the display module blocks removal of the first hot swappable module and the second hot swappable module in a third position.
15. The uninterruptible power supply device of clause 13 or 14, wherein the uninterruptible power supply device further comprises a removable front bezel configured to selectively cover the hot swappable modules and at least a portion of the display module, when the display module is in the third position.
16. The uninterruptible power supply device of any one of clauses 13-15, further comprising a mounting flange fixedly mounted to the frame, an intermediate linkage rotatably coupled to the mounting flange, and a display plate rotatably coupled to the intermediate linkage, wherein the display module is removably and fixedly coupled to the display plate.
17. The uninterruptible power supply device of clause 16, wherein the intermediate linkage is rotatably coupled to the display plate and the mounting flange through friction hinges.
18. The uninterruptible power supply device of clause 16, wherein the display plate is rotatably coupled to the intermediate linkage of the bracket through a display flange and wherein the display plate is removably coupled to the display flange.
19. An uninterruptible power supply device for a rack mounting system and configured to provide electrical power to at least one computing device, the uninterruptible power supply device comprising:
   a housing; a frame within the housing; a first hot swappable module coupled to the housing and disposed adjacent to the frame; a second hot swappable module coupled to the housing and disposed adjacent to the frame; a mounting flange fixedly mounted to the frame; an intermediate linkage rotatably coupled to the mounting flange; a display flange rotatably coupled to the intermediate linkage, wherein the intermediate linkage is rotatably coupled to the display flange and the mounting flange through friction hinges; a display plate coupled to the display flange; and a display module coupled to the display plate, wherein the display module selectively blocks removal of the first hot swappable module and allows removal of the second hot swappable module in a first position and wherein the display module selectively allows removal of the first hot swappable module and blocks removal of the second hot swappable module in a second position.
20. The uninterruptible power supply device of clause 19, wherein the display module blocks removal of the first hot swappable module and the second hot swappable module in a third position and wherein the uninterruptible power supply device further comprises a removable front bezel configured to selectively cover the hot swappable modules and at least a portion of the display module, when the display module is in the third position.

The description is set out in the context of preferred and other examples and not every example has been described. Obvious modifications and alterations to the described examples are available to those of ordinary skill in the art having the benefits of the present disclosure. The disclosed and undisclosed examples are not intended to limit or restrict the scope or applicability of what is conceived of by the Applicant, but rather, in conformity with the patent laws, Applicant intends to fully protect all such modifications and improvements that come within the scope or range of equivalents of the following claims.

## Claims

1. A cabinet mounted computing system comprising:
a rack mounting system;
at least one computing device mounted to the rack mounting system; and
at least one uninterruptible power supply device mounted to the rack mounting system;
wherein the at least one uninterruptible power supply device is configured to provide electrical power to the at least one computing device;
wherein the at least one uninterruptible power supply device includes at least one hot swappable module coupled thereto and a display module rotatably coupled thereto; and
wherein the display module is configured to selectively block and selectively allow removal of the at least one hot swappable module.

2. The cabinet mounted computing system of claim 1, wherein the at least one uninterruptible power supply device further comprises a removable front bezel configured to selectively cover the at least one hot swappable module and at least a portion of the display module.

3. The cabinet mounted computing system of claim 1, wherein the at least one hot swappable module comprises a first hot swappable module and a second hot swappable module disposed at least partially within the at least one uninterruptible power supply device.

4. The cabinet mounted computing system of claim 3, wherein the display module blocks removal of the first hot swappable module and allows removal of the second hot swappable module in a first position and wherein the display module allows removal of the first hot swappable module and blocks removal of the second hot swappable module in a second position; and optionally
wherein the display module blocks removal of the first hot swappable module and the second hot swappable module in a third position; and optionally
wherein the at least one uninterruptible power supply device further comprises a removable front bezel configured to selectively cover the hot swappable modules and at least a portion of the display module, when the display module is in the third position.

5. The cabinet mounted computing system of claim 1, wherein the display module is rotatably mounted to a double hinged bracket of the at least one uninterruptible power supply device.

6. The cabinet mounted computing system of claim 5, wherein the display module is fixedly mounted to a display plate of the bracket.

7. The cabinet mounted computing system of claim 6, wherein the display plate is rotatably coupled to an intermediate linkage of the bracket; and optionally
wherein the intermediate linkage is rotatably coupled to a mounting flange of the bracket and wherein the mounting flange is fixedly mounted to the at least one uninterruptible power supply device; and optionally
wherein the intermediate linkage is rotatably coupled to the display plate and the mounting flange through friction hinges.

8. The cabinet mounted computing system of claim 6, wherein the display plate is rotatably coupled to the intermediate linkage of the bracket through a display flange and wherein the display plate is removably coupled to the display flange.

9. An uninterruptible power supply device for a rack mounting system and configured to provide electrical power to at least one computing device, the uninterruptible power supply device comprising:
a housing;
a frame within the housing;
a first hot swappable module coupled to the housing and disposed adjacent to the frame;
a second hot swappable module coupled to the housing and disposed adjacent to the frame; and
a display module rotatably coupled to the frame, wherein the display module selectively blocks removal of the first hot swappable module and allows removal of the second hot swappable module in a first position and wherein the display module selectively allows removal of the first hot swappable module and blocks removal of the second hot swappable module in a second position.

10. The uninterruptible power supply device of claim 9, wherein the display module blocks removal of the first hot swappable module and the second hot swappable module in a third position.

11. The uninterruptible power supply device of claim 10, wherein the uninterruptible power supply device further comprises a removable front bezel configured to selectively cover the hot swappable modules and at least a portion of the display module, when the display module is in the third position.

12. The uninterruptible power supply device of claim 9, further comprising a mounting flange fixedly mounted to the frame, an intermediate linkage rotatably coupled to the mounting flange, and a display plate rotatably coupled to the intermediate linkage, wherein the display module is removably and fixedly coupled to the display plate.

13. The uninterruptible power supply device of claim 12, wherein the intermediate linkage is rotatably coupled to the display plate and the mounting flange through friction hinges; or optionally
wherein the display plate is rotatably coupled to the intermediate linkage of the bracket through a display flange and wherein the display plate is removably coupled to the display flange.

14. The uninterruptible power supply device of claim 1, further comprising:
a mounting flange fixedly mounted to the frame;
an intermediate linkage rotatably coupled to the mounting flange;
a display flange rotatably coupled to the intermediate linkage, wherein the intermediate linkage is rotatably coupled to the display flange and the mounting flange through friction hinges;
a display plate coupled to the display flange; and
wherein the display module is coupled to the display plate.

15. The uninterruptible power supply device of claim 14, wherein the display module blocks removal of the first hot swappable module and the second hot swappable module in a third position and wherein the uninterruptible power supply device further comprises a removable front bezel configured to selectively cover the hot swappable modules and at least a portion of the display module, when the display module is in the third position.
